# FASCICULE DE BREVET EUROPEEN

(11) **EP 0 800 210 B1**
(45) Date de publication et mention de la délivrance du brevet: **04.09.2002**
(21) Numéro de dépôt: 97400698.3
(22) Date de dépôt: 27.03.1997
(51) Int. Cl.: H01L 23/66, H01P 1/04

(54) **Module hyperfréquence compact**
Kompakter Mikrowellenmodul
Compact microwave module

(30) Priorité: 04.04.1996 FR 9604249
(43) Date de publication de la demande: 08.10.1997
(73) Titulaire: ALCATEL SPACE INDUSTRIES, 92000 Nanterre (FR)
(72) Inventeur: Tronche, Christian, 31200 Toulouse (FR); Monfraix, Philippe, 31400 Toulouse (FR); Coello Vera,Augustin, 31820 Pibrac (FR)
(74) Mandataire: Smith, Bradford Lee

(56) Documents cités:
- WO-A-93/16491
- WO-A-95/05005
- FR-A- 2 697 374
- US-A- 4 899 118
- US-A- 5 294 897
- US-A- 5 406 125

## Description

La présente invention concerne de manière générale un module hyperfréquence ainsi qu'un procédé de fabrication d'un tel module. A titre non limitatif, un tel module est utilisé par exemple pour former l'un d'une pluralité de modules actifs à élément rayonnant d'une antenne active, ces modules étant disposés matriciellement. Le terme "hyperfréquence" est associé dans la suite de la description tant à la plage des ondes centimétriques que des ondes millimétriques.

Le document US-A-5 294 897 propose une structure mono-composant à ligne coplanaire. La structure présentée comprend un substrat diélectrique sur lequel sont montées une portion de ligne coplanaire d'entrée et une portion de ligne coplanaire de sortie respectivement appliquées en entrée et en sortie d'un circuit intégré. Chaque portion de ligne coplanaire - d'entrée et de sortie - comprend une partie supérieure portée par une face supérieure du substrat, une partie intermédiaire traversant le substrat et une partie inférieure portée par le plan de la face inférieure du substrat. Ces parties supérieure, intermédiaire et inférieure prennent la forme générale d'une "marche d'escalier", les deux conducteurs de masse périphériques et le conducteur de masse central de cette partie inférieure de ligne coplanaire étant destinés à être mis en contact avec des bornes correspondantes d'un circuit imprimé. Cette réalisation présente l'inconvénient principal que l'association de plusieurs composants, assurant chacun une fonction donnée, telle qu'amplification, déphasage, etc..., requiert une surface de support importante. En outre, selon cette réalisation, une onde se propage sur ligne coplanaire de composant à composant en traversant un milieu non homogène parfois formé par une couche de substrat, parfois formé par l'air.

Pour remédier à l'inconvénient de la surface de support importante requise selon cette première réalisation, il est connu selon la technique antérieure, par exemple rappelée dans le document FR-A-2 697 374, de recourir à un module hyperfréquence compact comprenant une pluralité de structures élémentaires empilées, chaque structure étant constituée par un ou plusieurs circuits intégrés, ou puces, enrobés dans un diélectrique. Dans ce document, une liaison entre deux circuits intégrés appartenant à deux structures respectives distinctes est établie par un fil qui traverse la zone diélectrique séparant ces deux circuits à travers un trou formé dans cette zone. Cette réalisation présente l'inconvénient principal d'une mauvaise propagation d'une onde à fréquence élevée à travers cette liaison filaire.

L'invention vise donc à remédier aux inconvénients précités en fournissant un module hyperfréquence particulièrement compact et inhibant sensiblement toute perturbation dans les signaux radioélectriques transmis entre circuits.

A cette fin, selon une première réalisation de l'invention, un module hyperfréquence comprenant:
- une pluralité de structures élémentaires empilées formant bloc, chaque structure élémentaire comprenant une couche diélectrique inférieure sur une surface supérieure de laquelle est disposé un circuit intégré, et une couche diélectrique supérieure recouvrant le circuit, et
- une ligne de connexion pour connecter un premier circuit intégré monté sur une couche diélectrique d'une première structure parmi ladite pluralité de structures à un second circuit intégré monté sur une couche diélectrique d'une seconde structure parmi ladite pluralité de structures,
est caractérisé en ce que la ligne de connexion comprend une ligne coplanaire d'entrée disposée sur la surface supérieure de la couche diélectrique inférieure de la première structure, une ligne coplanaire de sortie disposée sur la surface supérieure de la couche diélectrique inférieure de la seconde structure, et une ligne coplanaire de liaison reliant une extrémité de la ligne coplanaire d'entrée et une extrémité de la ligne coplanaire de sortie.

Afin d'assurer un blindage et un bon drain thermique, une structure élémentaire donnée est séparée d'une structure élémentaire immédiatement adjacente par un élément de masse.

Dans ce cas, la portion de ligne coplanaire d'entrée et ladite ligne coplanaire de sortie s'étendent toutes deux au-delà d'un plan délimitant chaque rebord respectif du ou des éléments de masse séparant lesdites première et seconde structures élémentaires, de sorte que ladite ligne coplanaire de liaison est distante vers l'extérieur du ou des élément(s) de masse.

Un procédé de fabrication d'un tel module comprend les étapes de :
- moulage d'un bloc parallélépipédique comprenant une pluralité de structures élémentaires empilées, chaque structure élémentaire comprenant une couche diélectrique inférieure sur une surface supérieure de laquelle est disposé un circuit intégré et une couche diélectrique supérieure recouvrant le circuit,
- découpe dudit bloc suivant des plans de coupe parallèles et intérieurs respectivement à des faces en regard dudit bloc pour faire apparaître deux nouvelles faces sur chacune desquelles apparaissent des ensembles respectifs d'extrémités de conducteurs de masse et conducteur de signal chacun associé à une ligne coplanaire,
- métallisation desdites deux nouvelles faces, et
- gravure desdites deux nouvelles faces métallisées pour former une ligne coplanaire de liaison reliant des extrémités de conducteurs de masse et conducteur de signal d'une ligne coplanaire d'entrée d'une première structure élémentaire à des extrémités respectives de conducteurs de masse et conducteur de signal d'une ligne coplanaire de sortie d'une seconde structure élémentaire.

Dans le cas ou des éléments, ou plans, de masse sont prévus pour séparer deux structures élémentaires, le procédé comprend, en outre, les étapes de:
- remoulage du bloc gravé pour recouvrir la ligne coplanaire de liaison d'une enveloppe diélectrique,
- attaque du bloc gravé remoulé sur au moins l'une de ses faces en des points en regard avec les chants des plans de masse, de sorte à former des perforations d'accès entre chaque plan de masse et l'extérieur, et
- blindage du bloc par métallisation totale du bloc, ledit blindage étant en connexion électrique avec les plans de masse à travers lesdites perforations d'accès métallisées.

Selon une seconde variante de l'invention, un module compact hyperfréquence comprenant:
- une pluralité de structures élémentaires empilées formant bloc, chaque structure élémentaire comprenant une couche diélectrique inférieure sur une surface supérieure de laquelle est disposé un circuit intégré et une couche diélectrique supérieure recouvrant le circuit, et
- une ligne de connexion pour connecter un premier circuit intégré monté sur une couche diélectrique inférieure d'une première structure parmi ladite pluralité de structures à un second circuit intégré monté sur une couche diélectrique inférieure d'une seconde structure parmi ladite pluralité de structures,
est caractérisé selon l'invention en ce qu'il comprend, en outre,
- un élément de masse pour séparer chaque structure élémentaire donnée d'une structure élémentaire immédiatement adjacente, et en ce que
ladite ligne de connexion comprend une ligne coplanaire d'entrée qui est disposée sur la surface supérieure de la couche diélectrique inférieure de la première structure, une ligne coplanaire de sortie qui est disposée sur la surface supérieure de la couche diélectrique inférieure de la seconde structure, et une ligne de liaison comprenant, d'une part, un premier brin conducteur de signal reliant un conducteur de signal de la ligne coplanaire d'entrée et un conducteur de signal de la ligne coplanaire de sortie à travers un premier trou traversant chaque couche diélectrique inférieure et supérieure ainsi que chaque élément de masse séparant lesdites deux circuits, et, d'autre part, au moins un second brin conducteur de masse reliant au moins l'un des conducteurs de masse de la ligne coplanaire d'entrée à au moins l'un des conducteurs de masse de la ligne coplanaire de sortie à travers un second trou respectif traversant chaque couche diélectrique inférieure et supérieure ainsi que chaque élément de masse séparant lesdits deux circuits.

Avantageusement, ledit au moins un second brin conducteur de masse est en contact avec chaque élément de masse séparant les deux circuits.

Ledit au moins un second brin conducteur de masse est par exemple formé par métallisation d'un second trou.

En outre, les deux conducteurs de masse de chacune des lignes coplanaires d'entrée et de sortie peuvent être reliées entre eux à leurs extrémités respectives par un conducteur de masse additionnel.

L'on peut prévoir, une pluralité de seconds brins reliant entre eux les conducteurs de masse et conducteur de masse additionnel de la ligne coplanaire d'entrée et les conducteurs de masse et conducteur de masse additionnel de la ligne coplanaire de sortie, cette pluralité de seconds brins étant disposée en arc de cercle.

D'autres caractéristiques et avantages de la présente invention apparaîtront plus clairement à la lecture de la description suivante, en référence aux dessins annexés correspondants, dans lesquels :
- la figure 1 est une vue en perspective d'un module hyperfréquence selon l'invention, dans laquelle est représentée une liaison par ligne coplanaire entre deux circuits intégrés;
- la figure 2 est une vue en coupe transversale du module de la figure 1;
- la figure 3 montre, selon une première variante de l'invention, une vue en perspective détaillée d'une liaison par ligne coplanaire entre deux circuits intégrés appartenant respectivement à deux étages distincts du module;
- la figure 4 montre, selon une seconde variante de l'invention, une vue en perspective détaillée d'une liaison par trou métallisé entre deux circuits intégrés appartenant respectivement à deux étages distincts du module;
- la figure 5 est une vue en coupe de la réalisation de la figure 4;
- la figure 6 est une vue en coupe transversale d'un module selon l'invention en cours de fabrication; et
- la figure 7 est une vue en coupe transversale du module pour illustrer des plans de coupe successifs définis lors cette fabrication pour l'obtention d'un module selon l'invention.

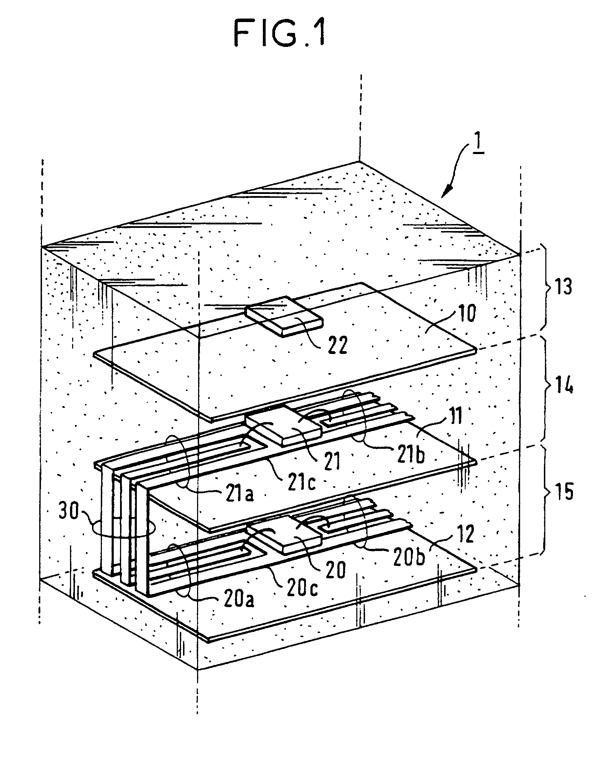

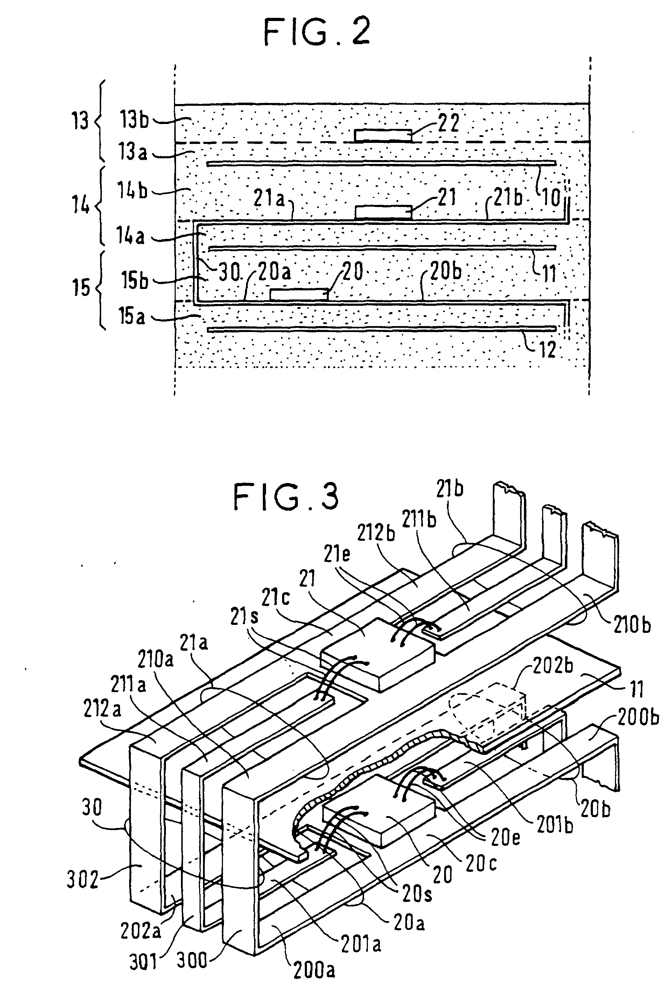

En référence aux figures 1 et 2, un module hyperfréquence selon l'invention comprend au moins deux de structures élémentaires empilées qui forment ensemble un bloc. Chaque structure élémentaire comprend un ou plusieurs circuits intégrés, ou puces, 20, 21, 22 qui sont disposés entre deux couches de substrat diélectrique qui forme ensemble une enveloppe diélectrique 15, 14, 13 du ou des circuits intégrés de la structure élémentaire considérée. Ainsi, à titre d'exemple, pour la structure élémentaire incluant le circuit 20, ce circuit 20 est logé dans l'enveloppe diélectrique 15 constitué d'une couche diélectrique inférieure 15a sur une surface supérieure de laquelle est disposé le circuit intégré 20, et d'une couche diélectrique supérieure 15b recouvrant le circuit. En pratique, l'on distingue les couches diélectriques inférieure - 15a, 14a, 13a - et supérieure - 15b, 14b, 13b - de chaque structure élémentaire car elles sont implantées successivement lors de la fabrication du module, comme cela apparaîtra plus clairement dans la suite de la description. Chaque structure élémentaire peut être séparée d'une structure élémentaire immédiatement adjacente par un plan de masse 10, 11, 12. Entre deux structures élémentaires immédiatement adjacentes inférieure et supérieure, le plan de masse 11 est typiquement disposé entre la couche diélectrique inférieure 14a de la structure élémentaire supérieure et la couche diélectrique supérieure 15b de la structure élémentaire inférieure. Dans les figures 1 et 2, le plan de masse 11 sépare la structure élémentaire incluant le composant 20 de la structure élémentaire incluant le composant 21.

Il va maintenant être décrit avec plus de détails, selon une première réalisation de l'invention, une liaison par ligne coplanaire entre deux circuits intégrés 20 et 21 appartenant respectivement à deux structures élémentaires. Dans cette liaison par ligne coplanaire, il est supposé que le circuit 20 produit en sortie un signal à appliquer à une entrée du circuit 21. Dans les figures annexées, les deux circuits intégrés 20 et 21 appartiennent respectivement à deux structures élémentaires qui sont immédiatement adjacentes. Néanmoins, l'homme du métier conviendra que les structures élémentaires auxquelles appartiennent les circuits 20 et 21 peuvent être séparées par une ou plusieurs autre(s) structure(s) élémentaire(s).

En se référant, en outre, à la figure 3, le circuit 21 est monté sur et mis à la masse par un conducteur de masse de support 21c, et est connecté à une ligne coplanaire d'entrée 21a et une ligne coplanaire de sortie 21b. Les conducteur de masse de support 21c, ligne coplanaire d'entrée 21a et ligne coplanaire de sortie 21b sont portés par la couche diélectrique inférieure 14a de la structure élémentaire incluant le circuit 21. La ligne coplanaire d'entrée 21a, respectivement de sortie 21b, comprend deux éléments conducteurs de masse 210a et 212a, respectivement 210b et 212b, encadrant et coplanaires avec un élément conducteur de signal 211a, respectivement 212a. Les deux éléments conducteurs de masse 210a et 212a de la ligne coplanaire d'entrée 21a et les deux éléments conducteurs de masse 210b et 212b de la ligne coplanaire de sortie 21b sont reliés au conducteur de masse de support 21c pour prendre la forme générale d'une structure plane en H. L'élément conducteur de signal 211a est disposé coplanairement entre les deux branches 210a et 212a de la structure plane en H et l'élément conducteur de signal 211b est disposé coplanairement entre les deux branches 210b et 212b de cette structure plane en H. Des extrémités respectives des éléments conducteurs de signal 211a et 211b, en regard avec le conducteur de masse de support 21c, sont connectées avec des supports d'électrode du circuit 21 par des fils courbés 21e et 21s, respectivement. De même, le circuit 20 est monté sur et mis à la masse par un conducteur de masse de support 20c, et est connecté à une ligne coplanaire d'entrée 20b et une ligne coplanaire de sortie 20a. Les conducteur de masse de support 20c, ligne coplanaire d'entrée 20b et ligne coplanaire de sortie 20a sont portés par la couche diélectrique inférieure 15a de la structure élémentaire incluant le circuit 20. La ligne coplanaire d'entrée 20b, respectivement de sortie 20a, comprend deux éléments conducteurs de masse 200b et 202b, respectivement 200a et 202a, encadrant et coplanaires avec un élément conducteur de masse 201b, respectivement 201a. Les deux éléments conducteurs de masse 200b et 202b de la ligne coplanaire d'entrée 20b et les deux éléments conducteurs de masse 200a et 202a de la ligne coplanaire de sortie 20a sont reliés au conducteur de masse de support 20c pour prendre la forme générale d'une structure plane en H. L'élément conducteur de signal 201b est disposé coplanairement entre les deux branches 200b et 202b de la structure plane en H et l'élément conducteur de signal 201a est disposé coplanairement entre les deux branches 200a et 202b de cette structure plane en H. Des extrémités respectives des éléments conducteurs de signal 201b et 201a, en regard avec le conducteur de masse de support 20c, sont connectées avec des supports d'électrode du circuit 20 par des fils courbés 20e et 20s, respectivement.

Une ligne coplanaire intermédiaire de liaison 30, comprenant deux conducteurs de masse 300 et 302, encadrant et coplanaires avec un élément conducteur de signal 301, établit une connexion entre la ligne coplanaire de sortie 20a et la ligne coplanaire d'entrée 21a. Le conducteur de masse 300, respectivement 302, relie une extrémité du conducteur de masse 210a, respectivement 212a, de la ligne coplanaire d'entrée 21a à une extrémité du conducteur de masse 200a, respectivement 202a, de la ligne coplanaire de sortie 20a. Le conducteur de signal 301 relie une extrémité du conducteur de signal 211a de la ligne coplanaire d'entrée 21a à une extrémité du conducteur de signal 201a de la ligne coplanaire de sortie 20a.

Une telle liaison multi-niveaux "tout en ligne coplanaire" entre deux circuits appartenant respectivement à deux structures élémentaires empilées offre une grande compacité du module résultant tout en garantissant une bonne propagation du signal entre les deux circuits 20 et 21. Cette bonne propagation du signal entre les deux circuits 20 et 21 est assurée malgré la disposition perpendiculaire de la ligne coplanaire intermédiaire de liaison 30 par rapport aux lignes coplanaires d'entrée et de sortie 21a et 20a. Cela résulte de la forme des lignes de champ se propageant dans les lignes coplanaires, ces lignes de champ étant sensiblement transversales aux lignes coplanaires. Typiquement, pour une ligne coplanaire, les lignes de champ entre l'un des deux conducteurs de masse et le conducteur de signal et les lignes de champ entre l'autre de ces deux conducteurs de masse et le conducteur de signal sont de sens opposés.

En pratique, la propagation dans une ligne coplanaire peut ne pas s'effectuer selon ce mode fondamental coplanaire idéal quasi TEM dans lequel les champs électriques s'appliquent entre chaque conducteur de masse et le conducteur de signal. D'autres modes parasites viennent alors s'ajouter qu'il convient d'atténuer, voire d'inhiber, notamment par une géométrie appropriée des lignes coplanaires et une épaisseur de substrat à définir.

Parmi ces modes parasites, l'on notera notamment le mode "micro ruban" et le mode de volume "à plans parallèles". Le premier de ces modes se caractérise par un champ électrique entre le conducteur de signal, par exemple 211a, et le plan de masse immédiatement inférieur 11, le second de ces modes définissant un champ électrique entre, d'une part, le conducteur de signal et les conducteurs de masse, et, d'autre part, le plan de masse immédiatement inférieur. Le premier de ces modes peut être atténué en choisissant une largeur du conducteur de signal 211a bien inférieure à l'épaisseur du substrat, ou couche inférieure 14a. L'on peut également choisir une largeur de fente entre conducteur de masse et conducteur de signal faible par rapport à l'épaisseur de la ligne coplanaire. L'on peut encore utiliser un substrat d'épaisseur relativement élevée, typiquement de l'ordre de 400 µm, sans que cette épaisseur soit trop importante car donnant naissance à un mode de type rectangulaire de type TE.

Comme montré dans la figure 3, dans le cas où un plan de masse 11 est prévu entre chaque structure élémentaire, la ligne coplanaire d'entrée 21a et la ligne coplanaire de sortie 20a s'étendent toutes deux au-delà d'un plan délimitant chaque rebord respectif du ou des éléments de masse séparant les structures élémentaires auxquelles appartiennent respectivement les circuits 20 et 21, de sorte que la ligne coplanaire de liaison est distante vers l'extérieur du ou des élément(s)) de masse séparant les deux structures considérées.

Avantageusement, dans tous les cas, la ligne coplanaire de liaison 30 est de préférence intégrée dans le module en étant recouverte d'une couche diélectrique, de sorte à éviter toute désadaptation électrique résultant de la propagation du signal dans des milieux, à savoir substrat et air, de permittivités respectives différentes.

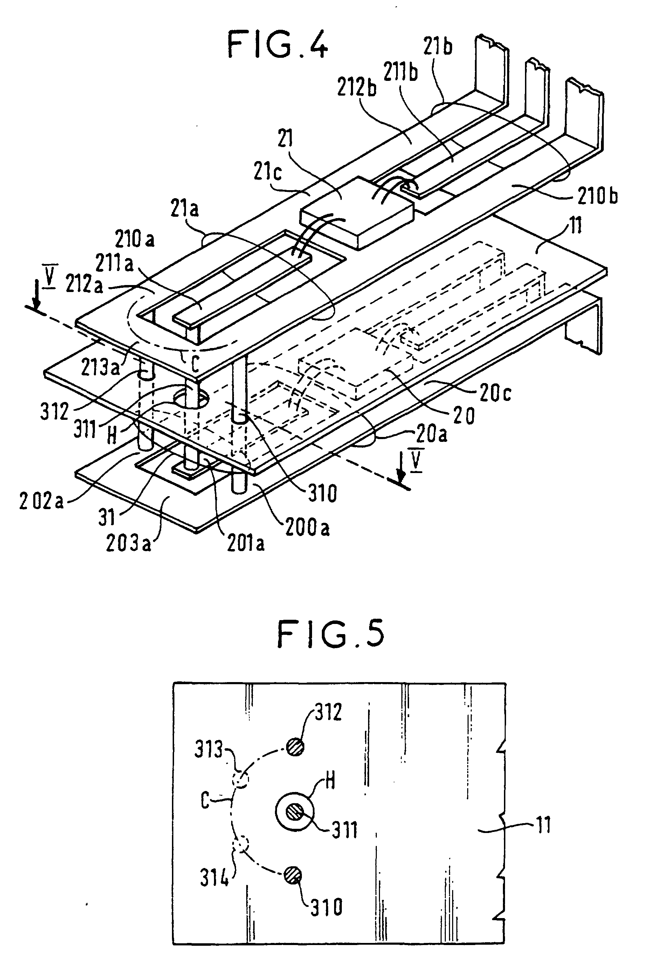

En référence aux figures 4 et 5, il est maintenant décrit une seconde réalisation de l'invention. Au même titre que dans la variante précédente, le circuit 21 est monté sur et mis à la masse par un conducteur de masse de support 21c, et est connecté à une ligne coplanaire d'entrée 21a et une ligne coplanaire de sortie 21b. Les conducteur de masse de support 21c, ligne coplanaire d'entrée 21a et ligne coplanaire de sortie 21b sont portés par la couche diélectrique inférieure 14a de la structure élémentaire incluant le circuit 21. La portion de ligne coplanaire d'entrée 21a, respectivement de sortie 21b, comprend deux éléments conducteurs de masse 210a et 212a, respectivement 210b et 212b, encadrant et coplanaires avec un élément conducteur de masse 211a, respectivement 212a. Les deux éléments conducteurs de masse 210a et 212a de la ligne coplanaire d'entrée 21a et les deux éléments conducteurs de masse 210b et 212b de la ligne coplanaire de sortie 21b sont reliés au conducteur de masse de support 21c pour prendre la forme générale d'une structure plane en H. L'élément conducteur de signal 211a est disposé coplanairement entre les deux branches 210a et 212a de la structure plane en H et l'élément conducteur de signal 211b est disposé coplanairement entre les deux branches 210b et 212b de cette structure plane en H. Des extrémités respectives des éléments conducteurs de signal 211a et 211b, en regard avec le conducteur de masse de support 21c, sont connectées avec des supports d'électrode du circuit 21 par des fils courbés 21e et 21s, respectivement. Par ailleurs, le circuit 20 est monté sur et mis à la masse par un conducteur de masse de support 20c, et est connecté à une ligne coplanaire d'entrée 20b et une ligne coplanaire de sortie 20a. Les conducteur de masse de support 20c, ligne coplanaire d'entrée 20b et ligne coplanaire de sortie 20a sont portés par la couche diélectrique inférieure 15a de la structure élémentaire incluant le circuit 20. La ligne coplanaire d'entrée 20b, respectivement de sortie 20a, comprend deux éléments conducteurs de masse 200b et 202b, respectivement 200a et 202a, encadrant et coplanaires avec un élément conducteur de masse 201b, respectivement 201a. Les deux éléments conducteurs de masse 200b et 202b de la ligne coplanaire d'entrée 20b et les deux éléments conducteurs de masse 200a et 202a de la ligne coplanaire de sortie 20a sont reliés au conducteur de masse de support 20c pour prendre la forme générale d'une structure plane en H. L'élément conducteur de signal 201b est disposé coplanairement entre les deux branches 200b et 202b de la structure plane en H et l'élément conducteur de signal 201a est disposé coplanairement entre les deux branches 200a et 202b de cette structure plane en H. Des extrémités respectives des éléments conducteurs de signal 201b et 201a, en regard avec le conducteur de masse de support 20c, sont connectées avec des supports d'électrode du circuit 20 par des fils courbés 20e et 20s, respectivement. Dans cette seconde variante, chaque structure élémentaire donnée est séparée d'une structure élémentaire immédiatement adjacente par un plan de masse 11. Avantageusement, les deux conducteurs de masse 210a et 212a de la ligne coplanaire d'entrée 21a sont reliées entre eux à leurs extrémités respectives par un conducteur de masse additionnel 213a disposé perpendiculairement aux conducteurs de masse, et les deux conducteurs de masse 200a et 202a de la ligne coplanaire de sortie 20a sont reliées entre eux à leurs extrémités respectives par un conducteur de masse additionnel 203a.

Dans cette seconde variante, la liaison entre la ligne coplanaire de sortie 20a et la ligne coplanaire d'entrée 21a est assurée par, d'une part, un premier brin conducteur de signal 311 reliant le conducteur de signal 211a de la ligne coplanaire d'entrée 21a et le conducteur de signal 201a de la ligne coplanaire de sortie 20a à travers un trou H traversant chaque couche diélectrique inférieure et supérieure ainsi que chaque plan de masse 11 séparant les deux circuits 20 et 21, et, d'autre part, au moins un second brin conducteur de masse 310, 312 reliant au moins l'un des conducteurs de masse 210a, 212a de la ligne coplanaire d'entrée 21a à au moins l'un des conducteurs de masse 200A, 202a de la ligne coplanaire de sortie 21a à travers un trou traversant chaque couche diélectrique inférieure et supérieure ainsi que chaque élément de masse séparant les deux circuits 20 et 21.

Typiquement, chacun des seconds brins conducteurs de masse 310, 312 est formé par métallisation de trou. Ainsi, le brin métallisé occupe la totalité du trou qu'il traverse. En outre, afin d'assurer une parfaite homogénéité des potentiels de masse, chacun des seconds brins conducteurs de masse 310, 312 est en contact avec chaque plan de masse qui séparent les deux circuits 20 et 21. Selon une variante, un second brin de masse est constitué d'une pluralité de portions de brins. Si N désigne le nombre de plans de masse séparant les deux circuits 20 et 21, (N+1) portions de brins de masse sont prévues. Par rapport à un plan de masse donné, les extrémités de deux des (N+1) portions de brins de masse sont fixés en regard de part et d'autre du plan de masse.

Dans la figure 4, seuls deux brins conducteurs de masse 310 et 312 sont représentés. Néanmoins, comme montré dans la figure 5, de manière tout à fait avantageuse, plusieurs seconds brins 310, 312, 313 et 314 peuvent être utilisés pour relier entre eux les conducteurs de masse 200a, 202a et conducteur de masse additionnel 203a de la ligne coplanaire de sortie 20a et lesdits conducteurs de masse 210a, 212a et conducteur de masse additionnel 213a de la ligne coplanaire d'entrée 21a. Au niveau d'une ligne coplanaire, telle que 21a, des extrémités respectives de ces seconds brins viennent au contact de la surface inférieure des conducteurs de masse 210a, 212a et conducteur de masse additionnel 213a de la ligne coplanaire d'entrée 21a, ces points de contact définissant par exemple un arc de cercle. En pratique toute autre disposition peut être utilisée, en prévoyant plusieurs seconds brins entourant au moins partiellement le brin conducteur de signal 311. Cette alternative offre une propagation du signal entre ligne coplanaire de sortie 20a et ligne coplanaire d'entrée 21a de type ligne coaxiale, en raison de la disposition "périphérique" des seconds brins conducteurs de masse 310, 312, 313 et 314 autour du brin conducteur de signal 311.

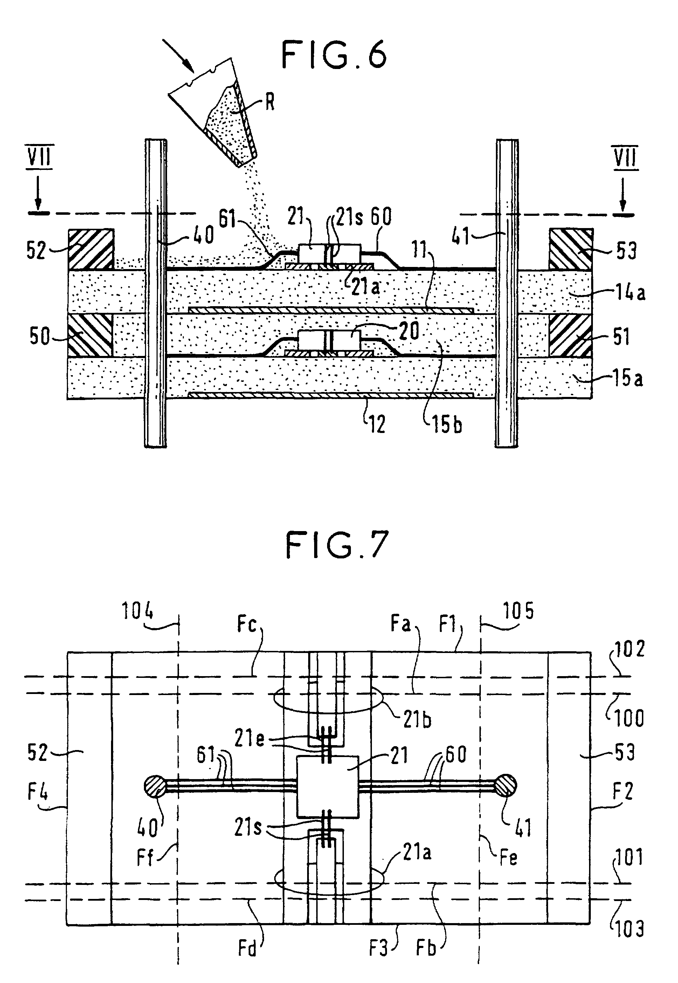

En référence aux figures 6 et 7, il est maintenant présenté un procédé de fabrication d'un module selon l'invention, tel que décrit en référence aux figures 1 à 3.

Pour ce procédé, il est prévu un moule de forme parallélépipédique (non représenté) sur un fond obturé duquel se dresse des moyens de guidage, par exemple sous la forme de deux tiges allongées 40 et 41. Une première structure élémentaire du module hyperfréquence compact selon l'invention est alors formée par introduction dans le moule de la couche diélectrique inférieure, ou substrat, 15a de la structure élémentaire considérée, cette couche supportant sur sa face supérieure les lignes coplanaires d'entrée et de sortie 20a et 20b ainsi que le circuit intégré 20. Le substrat 15a est muni de deux perforations transversales pour être guidé par les deux tiges allongées 40 et 41 lors de son introduction dans le moule. Puis de la résine R est déposée sur la face supérieure du substrat 15a pour former la couche supérieure 15b qui recouvre les lignes coplanaires d'entrée et de sortie 20a et 20b ainsi que le circuit intégré 20. Ensuite, une seconde structure élémentaire du module hyperfréquence compact est alors formée par introduction dans le moule de la couche diélectrique inférieure, ou substrat, 14a de cette seconde structure élémentaire, cette couche inférieure supportant sur sa face supérieure les lignes coplanaires d'entrée et de sortie 21a et 21b ainsi que le circuit intégré 21. De la résine R est alors déposée sur la face supérieure du substrat 14a pour former la couche supérieure 14b qui recouvre les lignes coplanaires d'entrée et de sortie 21a et 21b ainsi que le circuit intégré 21. Par réitération de ces opérations, une pluralité de structures élémentaires peuvent ainsi être empilées. Des entretoises 50, 51, respectivement 52, 53 disposées latéralement peuvent être prévues pour séparer les couches inférieures 15a, 14a ainsi successivement introduites, assurant ainsi une disposition parallèle de ces dernières. Après empilement du nombre souhaité de structures élémentaires, l'on démoule la structure résultante qui se présente sous la forme d'un parallélépipède.

En référence à la figure 7, cette structure parallélépipédique définissant quatre faces latérales F1, F2, F3 et F4 est ensuite découpée suivant les plans de coupe 100 et 101 parallèles et intérieurs respectivement aux faces en regard F1 et F3, faisant apparaître deux nouvelles faces Fa et Fb. Sur chacune ces deux faces Fa et Fb, apparaissent des extrémités respectives des conducteurs de masse et conducteur de signal des lignes coplanaires - d'entrée ou de sortie - des différentes structures élémentaires. Ces deux faces Fa et Fb sont alors métallisées par recouvrement de métal. Les faces métallisées résultantes sont ensuite gravées pour former chaque ligne intermédiaire de liaison 30 existante entre une ligne coplanaire d'entrée et une ligne coplanaire de sortie. Cette gravure est obtenue par suppression d'une partie de la surface métallisée sur les deux faces Fa et Fb.

La structure parallélépipédique modifiée ainsi obtenue est réintroduite dans le moule en étant guidée par les deux tiges allongées 40 et 41. De la résine est injectée sur les côtés extérieurs des faces Fa et Fb de sorte à former une structure parallélépipédique remoulée de dimension égale à la dimension de la première structure. Cette structure est alors démoulée pour être découpée, d'une part, suivant des plans de coupe 102 et 103 parallèles et intérieurs respectivement aux faces en regard F1 et F3, et, d'autre part, suivant des plans de coupe 104 et 105 parallèles et intérieurs respectivement aux faces en regard F4 et F2. Est alors obtenue une structure parallélépipédique finale définie par les quatre faces latérales Fc, Fd, Fe et Ff. Les faces Fc et Fd sont naturellement extérieures respectivement aux faces Fa et Fb sur lesquelles sont inscrites les lignes coplanaires intermédiaires de liaison 30. Lorsqu'un plan de masse 11, 12 est prévu pour séparer deux modules immédiatement adjacents, pour chaque plan de masse, il est prévu d'attaquer, typiquement par laser, la résine sur au moins l'une des faces Fc, Fd, Fe et Ff en des points en regard avec les chants de ce plan de masse de sorte à former une perforation d'accès entre le plan de masse et l'extérieur. La structure finale est ensuite métallisée sur toute sa surface en incluant les perforations d'accès. Cette enveloppe métallisée constitue un blindage du module, ce blindage étant en connexion électrique avec les plan de masse 11, 12.

Il n'a pas été fait mention jusqu'à présent des fils basse fréquence, ou BF, typiquement d'alimentation des circuits 20 et 21. Comme montré dans la figure 7, pour chaque structure élémentaire, ces fils 60, 61 sont portés par la face supérieure de la couche inférieure, ou substrat, 14a, 15a sur laquelle est monté le circuit intégré 21, 20. Ces fils s'étendent vers les faces Fe et Ff. Ces faces Fe et Ff, qui sont métallisées en résultat de l'étape de métallisation décrite ci-dessus, sont alors gravées pour former chaque fil intermédiaire de liaison avec une source de signal BF.

En pratique, il est possible d'étendre ce qui vient décrit à une réalisation par fils basse fréquence multicouches. Dans ce cas, sont prévues des étapes itératives de moulage, attaque laser, métallisation de la face concernée et gravure. Une étape de moulage de rang P est destinée à recouvrir de résine la gravure des fils BF formée lors de l'étape de gravure de rang (P-1), une étape d'attaque laser de rang P étant destinée à former des perforations d'accès à cette gravure de rang (P-1), et les étape de métallisation et gravure de rang P ayant pour but de réaliser le motif multicouche de gravure BF souhaité.

## Revendications

1. Module hyperfréquence comprenant:
- une pluralité de structures élémentaires empilées formant bloc, chaque structure élémentaire comprenant une couche diélectrique inférieure (14a, 15a) sur une surface supérieure de laquelle est disposé un circuit intégré (20, 21), et une couche diélectrique supérieure (15a, 15b) recouvrant le circuit (20, 21), et
- une ligne de connexion (30) pour connecter un premier circuit intégré (20) monté sur une couche diélectrique d'une première structure parmi ladite pluralité de structures à un second circuit intégré (21) monté sur une couche diéléctrique d'une seconde structure parmi ladite pluralité de structures,
**caractérisé en ce que**
la ligne de connexion (20a, 30, 21a) comprend une ligne coplanaire d'entrée (21a) disposée sur la surface supérieure de la couche diélectrique inférieure de la première structure, une ligne coplanaire de sortie (20a) disposée sur la surface supérieure de la couche diélectrique inférieure de la seconde structure, et une ligne coplanaire de liaison (30) reliant une extrémité de la ligne coplanaire d'entrée et une extrémité de la ligne coplanaire de sortie,
une structure élémentaire donnée est séparée d'une structure élémentaire immédiatement adjacente par un élément de masse (10, 11), et
ladite portion de ligne coplanaire d'entrée (21a) et ladite ligne coplanaire de sortie (20a) s'étendent toutes deux au-delà d'un plan délimitant chaque rebord respectif du ou des éléments de masse (11) séparant lesdites première et seconde structures élémentaires, de sorte que ladite ligne coplanaire de liaison (30) est distante vers l'extérieur du ou des élément(s) de masse (11).

2. Module compact hyperfréquence comprenant:
- une pluralité de structures élémentaires empilées formant bloc, chaque structure élémentaire comprenant une couche diélectrique inférieure (14a, 15a) sur une surface supérieure de laquelle est disposé un circuit intégré (20, 21) et une couche diélectrique supérieure (14b, 15b) recouvrant le circuit (20, 21), et
- une ligne de connexion (20a, 31, 20b) pour connecter un premier circuit intégré (20) monté sur une couche diélectrique inférieure d'une première structure parmi ladite pluralité de structures à un second circuit intégré (21) monté sur une couche diélectrique inférieure d'une seconde structure parmi ladite pluralité de structures,
**caractérisé en ce qu'**il comprend, en outre,
- un élément de masse (10, 11) pour séparer chaque structure élémentaire donnée d'une structure élémentaire immédiatement adjacente, et **en ce que**
ladite ligne de connexion comprend une ligne coplanaire d'entrée (21a) qui est disposée sur la surface supérieure de la couche diélectrique inférieure de la premièré structure, une ligne coplanaire de sortie qui est disposée sur la surface supérieure de la couche diélectrique inférieure de la seconde structure, et une ligne de liaison comprenant, d'une part, un premier brin conducteur de signal (311) reliant un conducteur de signal (211a) de la ligne coplanaire d'entrée (21a) et un conducteur de signal (20a) de la ligne coplanaire de sortie (20a) à travers un premier trou (H) traversant chaque couche diélectrique inférieure et supérieure ainsi que chaque élément de masse séparant lesdites deux circuits, et, d'autre part, au moins un second brin conducteur de masse (310-314) reliant au moins l'un des conducteurs de masse de la ligne coplanaire d'entrée à au moins l'un des conducteurs de masse de la ligne coplanaire de sortie à travers un second trou respectif traversant chaque couche diélectrique inférieure et supérieure ainsi que chaque élément de masse séparant lesdits deux circuits (20, 21).

3. Module conforme à la revendication 2, **caractérisé en ce que** ledit au moins un second brin conducteur de masse est en contact avec chaque élément de masse séparant lesdits deux circuits (20, 21).

4. Module conforme à la revendication 2 ou 3, **caractérisé en ce que** ledit au moins un second brin conducteur de masse est formé par métallisation dudit second trou.

5. Module conforme à l'une quelconque des revendications 2 à 4, **caractérisé en ce que** les deux conducteurs de masse de chacune desdites lignes coplanaires d'entrée et de sortie sont reliées entre eux à leurs extrémités respectives par un conducteur de masse additionnel (203a, 213a).

6. Module conforme à la revendication 5, **caractérisé par** une pluralité de seconds brins (310-314) reliant entre eux lesdits conducteurs de masse et conducteur de masse additionnel de la ligne coplanaire d'entrée et lesdits conducteurs de masse et conducteur de masse additionnel de la ligne coplanaire de sortie, ladite pluralité de seconds brins conducteurs de signal entourant au moins partiellement ledit premier conducteur de signal.

7. Module conforme à la revendication 5, **caractérisé en ce que** ladite pluralité de seconds brins est disposée en arc de cercle autour dudit premier conducteur de signal.

8. Antenne active comprenant une pluralité de modules, **caractérisé en ce que** chacun de ces modules est conforme à l'une quelconque des revendications précédentes.

9. Procédé de fabrication d'un module conforme à la revendication 1, **caractérisé en ce qu'**il comprend les étapes de :
- moulage d'un bloc parallélépipédique comprenant une pluralité de structures élémentaires empilées, chaque structure élémentaire comprenant une couche diélectrique inférieure sur une surface supérieure de laquelle est disposé un circuit intégré (20, 21) et une couche diélectrique supérieure recouvrant le circuit,
- découpe (100, 101) dudit bloc suivant des plans de coupe parallèles et intérieurs respectivement à des faces en regard (F1, F2) dudit bloc pour faire apparaître deux nouvelles faces (Fa, Fb) sur chacune desquelles apparaissent des ensembles respectifs d'extrémités de conducteurs de masse et conducteur de signal chacun associé à une ligne coplanaire,
- métallisation desdites deux nouvelles faces (Fa, Fb), et
- gravure desdites deux nouvelles faces métallisées pour former une ligne coplanaire de liaison reliant des extrémités de conducteurs de masse et conducteur de signal d'une ligne coplanaire d'entrée d'une première structure élémentaire à des extrémités respectives de conducteurs de masse et conducteur de signal d'une ligne coplanaire de sortie d'une seconde structure élémentaire.

10. Procédé conforme à la revendication 9, **caractérisé en ce qu'**il comprend, en outre, les étapes de:
- remoulage du bloc gravé pour recouvrir la ligne coplanaire de liaison d'une enveloppe diélectrique, et
- attaque du bloc gravé remoulé sur au moins l'une de ses faces en des points en regard avec les chants d'un élément de masse de sorte à former des perforations d'accès entre chaque élément de masse et l'extérieur, et
- blindage du bloc par métallisation totale du bloc, ledit blindage étant en connexion électrique avec les éléments de masse à travers lesdites perforations d'accès métallisées.

11. Procédé conforme à la revendication 10, **caractérisé en ce qu'**il comprend, en outre, une étape de gravure d'au moins une face dudit bloc métallisé pour former des fils de liaison basse fréquence.

12. Procédé conforme à la revendication 11, **caractérisé par** des étapes itératives de remoulage dudit bloc métallisé gravé, attaque laser, métallisation puis gravure, pour la formation de fils basse fréquence multicouches.

## Patentansprüche

1. Mikrowellenmodul, welches umfasst:
- eine Vielzahl von einen Block formenden gestapelten Elementarstrukturen, wobei jede Elementarstruktur eine untere dielektrische Schicht (14a, 15a), auf deren Oberseite eine integrierte Schaltung (20, 21) angeordnet ist, und eine die Schaltung (20, 21) bedeckende obere dielektrische Schicht (14b, 15b) aufweist, und
- eine Anschlussleitung (30) zum Verbinden einer, auf einer dielektrischen Schicht einer ersten Struktur aus der genannten Vielzahl von Strukturen montierten, ersten integrierten Schaltung (20) mit einer, auf einer dielektrischen Schicht einer zweiten Struktur aus der genannten Vielzahl von Strukturen montierten, zweiten integrierten Schaltung (21),
**dadurch gekennzeichnet, dass**
die Anschlussleitung (20a, 30, 21a) eine auf der Oberseite der unteren dielektrischen Schicht der ersten Struktur angeordnete koplanare Eingangsleitung (21a), eine auf der Oberseite der unteren dielektrischen Schicht der zweiten Struktur angeordnete koplanare Ausgangsleitung (20a), und eine ein Ende der koplanaren Eingangsleitung und ein Ende der koplanaren Ausgangsleitung verbindende koplanare Verbindungsleitung (30) umfasst,
eine gegebene Elementarstruktur von einer unmittelbar angrenzenden Elementarstruktur durch ein Massenelement (10, 11) getrennt ist, und
die Abschnitte der koplanaren Eingangsleitung (21a) und der koplanaren Ausgangsleitung (20a) beide jenseits einer Fläche verlaufen, welche jeden Rand jeweils des oder der Massenelements (11) begrenzt, welches die ersten und zweiten Elementarstrukturen trennt, derart, dass die koplanare Verbindungsleitung (30) von dem oder den Massenelement(en) (11) nach außen hin einen Abstand aufweist.

2. Mikrowellenmodul, welches umfasst :
- eine Vielzahl von einen Block formenden gestapelten Elementarstrukturen, wobei jede Elementarstruktur eine untere dielektrische Schicht (14a, 15a), auf deren Oberseite eine integrierte Schaltung (20, 21) angeordnet ist, und eine die Schaltung (20, 21) bedeckende obere dielektrische Schicht (14b, 15b) aufweist, und
- eine Anschlussleitung (20a, 31, 20b) zum Verbinden einer, auf einer unteren dielektrischen Schicht einer ersten Struktur aus der genannten Vielzahl von Strukturen montierten, ersten integrierten Schaltung (20) mit einer, auf einer unteren dielektrischen Schicht einer zweiten Struktur aus der genannten Vielzahl von Strukturen montierten, zweiten integrierten Schaltung (21),
**dadurch gekennzeichnet, dass** es ferner
- ein Massenelement (10, 11) zum Trennen jeder gegebenen Elementarstruktur von einer unmittelbar benachbarten Elementarstruktur umfasst, und dass
- die Anschlussleitung eine koplanare Eingangsleitung (21a), welche auf der Oberseite der unteren dielektrischen Schicht der ersten Struktur angeordnet ist, eine koplanare Ausgangsleitung, welche auf der Oberseite der unteren dielektrischen Schicht der zweiten Struktur angeordnet ist, und eine Verbindungsleitung umfasst, welche einerseits eine erste Signalleiterader (311), die einen Signalleiter (211a) der koplanaren Eingangsleitung (21a) und einen Signalleiter (20a) der koplanaren Ausgangsleitung (20a) durch ein, jede untere und obere dielektrische Schicht sowie jedes die beiden Schaltkreise trennende Massenelement durchquerendes erstes Loch (H) hindurch verbindet, und andererseits wenigstens eine zweite Massenleiterader (310-314), welche wenigstens einen der Massenleiter der koplanare Eingangsleitung mit wenigstens einem der Massenleiter der koplanaren Ausgangsleitung durch ein entsprechendes, jede untere und obere dielektrische Schicht sowie jedes die beiden Schaltungen (20, 21) trennende Massenelement durchquerendes zweites Loch hindurch verbindet, aufweist.

3. Modul nach Anspruch 2,
**dadurch gekennzeichnet, dass** die wenigstens zweite Massenleiterader in Kontakt mit jedem die beiden Schaltungen (20, 21) trennenden Massenelement ist.

4. Modul nach Anspruch 2 oder 3,
**dadurch gekennzeichnet, dass** die wenigstens zweite Massenleiterader durch Metallisierung des zweiten Lochs geformt ist.

5. Modul nach einem der Ansprüche 2 bis 4,
**dadurch gekennzeichnet, dass** die beiden Massenleiter jeder koplanaren Eingangs- und Ausgangsleitung an ihren jeweiligen Enden durch einen zusätzlichen Massenleiter (203a, 213a) miteinander verbunden sind.

6. Modul nach Anspruch 5,
**dadurch gekennzeichnet, dass** eine Vielzahl von zweiten Adern (310-314) vorgesehen ist, welche die Massenleiter und den zusätzlichen Massenleiter der koplanaren Eingangsleitung und die Massenleiter und den zusätzlichen Massenleiter der koplanaren Ausgangsleitung miteinander verbinden, wobei die Vielzahl von zweiten Signalleitungsadern den ersten Signalleiter wenigstens teilweise umgibt.

7. Modul nach Anspruch 5,
**dadurch gekennzeichnet, dass** die Vielzahl von zweiten Adern in einem Kreisbogen um den ersten Signalleiter angeordnet ist.

8. Aktivantenne mit einer Vielzahl von Modulen nach einem der vorhergehenden Ansprüche.

9. Verfahren zur Herstellung eines Moduls nach Anspruch 1,
**dadurch gekennzeichnet, dass** es die folgenden Schritte aufweist:
- Gießen eines spatförmigen Blocks mit einer Vielzahl von gestapelten Elementarstrukturen, wobei jede Elementarstruktur eine untere dielektrische Schicht aufweist, auf deren Oberseite eine integrierte Schaltung (20, 21) angeordnet ist, und wobei eine obere dielektrische Schicht die Schaltung bedeckt,
- Schneiden (100, 101) des Blocks entlang paralleler Schnittebenen, die bezüglich der Seiten des Blocks (F1, F2) innen liegen, so dass zwei neue Flächen (Fa, Fb) entstehen, auf denen jeweils Anordnungen der Enden der Massenleiter und des Signalleiters, welche jeweils mit einer koplanaren Leitung verbunden sind, sichtbar werden,
- Metallisierung der beiden neuen Flächen (Fa, Fb), und Ätzen der beiden metallisierten neuen Flächen um eine koplanare Verbindungsleitung zu formen, welche die Enden der Massenleiter und des Signalleiters einer koplanaren Eingangsleitung einer ersten Elementarstruktur mit den jeweiligen Enden der Massenleiter und des Signalleiters einer koplanaren Ausgangsleitung einer zweiten Elementarstruktur verbindet.

10. Verfahren nach Anspruch 9,
**dadurch gekennzeichnet, dass** es ferner die folgenden Schritte aufweist:
- Umgießen des geätzten Blocks um die koplanare Verbindungsleitung mit einer dielektrischen Hülle zu bedecken, und
- Abtragen des umgossenen geätzten Blocks auf wenigstens einer seiner Seiten an Stellen gegenüber den Kanten der Massenebenen, um so Zugriffslöcher zwischen jeder Massenebene und dem Äußeren zu formen, und
- Abschirmung des Blocks durch eine gesamte Metallisierung des Blocks, wobei die Abschirmung durch die metallisierten Zugriffslöcher in elektrischer Verbindung mit den Massenebenen ist.

11. Verfahren nach Anspruch 10,
**dadurch gekennzeichnet, dass** es ferner einen Schritt zum Ätzen wenigstens einer Seite des metallisierten Blocks aufweist, um Niederfrequenzverbindungsdrähte zu formen.

12. Verfahren nach Anspruch 11,
**gekennzeichnet durch** die wiederholten Schritte Umgießen des geätzten metallisierten Blocks, Laserabtrag, Metallisierung und anschließendes Ätzen zur Bildung von mehrschichtigen Niederfrequenzverbindungsdrähten.

## Claims

1. A microwave module comprising:
a plurality of stacked elementary structures forming a unit, each elementary structure comprising a bottom dielectric layer (14a, 15a) on a top surface of which an integrated circuit (20, 21) is disposed, and a top dielectric layer (14b, 15b) covering the circuit (20, 21); and
a connection line (30) for connecting a first integrated circuit (20) mounted on a dielectric layer of a first structure of said plurality of structures to a second integrated circuit (21) mounted on a dielectric layer of a second structure of said plurality of structures;
said module being **characterized in that**:
the connection line (20a, 30, 21a) comprises an input coplanar line (21a) disposed on the top surface of the bottom dielectric layer of the first structure, an output coplanar line (20a) disposed on the top surface of the bottom dielectric layer of the second structure, and a link coplanar line (30) connecting one end of the input coplanar line to one end of the output coplanar line;
a given elementary structure is separated from an immediately adjacent elementary structure by a ground element (10, 11); and
both said input coplanar line (21a) and said output coplanar line (20a) extend beyond planes including the respective edges of the ground element(s) (11) separating said first elementary structure and said second elementary structure, so that said link coplanar line (30) is offset outwardly relative to the ground element(s) (11).

2. A compact microwave module comprising:
a plurality of stacked elementary structures forming a unit, each elementary structure comprising a bottom dielectric layer (14a, 15a) on a top surface of which an integrated circuit (20, 21) is disposed, and a top dielectric layer (14b, 15b) covering the circuit (20, 21); and
a connection line (20a, 31, 20b) for connecting a first integrated circuit (20) mounted on a bottom dielectric layer of a first structure of said plurality of structures to a second integrated circuit (21) mounted on a bottom dielectric layer of a second structure of said plurality of structures;
said module being **characterized in that** it further comprises:
a ground element (10, 11) for separating each given elementary structure from an immediately adjacent elementary structure;
and **in that** said connection line comprises an input coplanar line (21a) which is disposed on the top surface of the bottom dielectric layer of the first structure, an output coplanar line which is disposed on the top surface of the bottom dielectric layer of the second structure, and a link line comprising firstly a signal first conductor strand (311) connecting a signal conductor (211a) of the input coplanar line (21a) to a signal conductor (201a) of the output coplanar line (20a) via a first hole (H) through each bottom and top dielectric layer and through each ground element separating said two circuits, and secondly at least one grounding second conductor strand (310-314) connecting at least one of the grounding conductors of the input coplanar line to at least one of the grounding conductors of the output coplanar line via a respective second hole passing through each bottom and top dielectric layer and through each ground element separating said two circuits (20, 21).

3. A module according to claim 2, **characterized in that** said at least one grounding second conductor strand is in contact with each ground element separating said two circuits (20, 21).

4. A module according to claim 2 or 3, **characterized in that** said at least one grounding second conductor strand is formed by metal plating said second hole.

5. A module according to any one of claims 2 to 4, **characterized in that** the two grounding conductors of each of said input and output coplanar lines are connected together at their respective ends via an additional grounding conductor (203a, 213a).

6. A module according to claim 5, **characterized by** a plurality of second strands (310-314) connecting together said grounding conductors and said additional grounding conductor of the input coplanar line and said grounding conductors and said additional conductor of the output coplanar line, said plurality of ground second conductor strands surrounding at least in part said signal first conductor.

7. A module according to claim 5, **characterized in that** said plurality of second strands is disposed in a circular arc around said signal first conductor.

8. An active antenna comprising a plurality of modules, said antenna being **characterized in that** each of the modules is a module according to any preceding claim.

9. A method of manufacturing a module according to claim 1, **characterized in that** it includes the following steps:
molding a rectangular unit comprising a plurality of stacked elementary structures, each elementary structure comprising a bottom dielectric layer on a top surface of which an integrated circuit (20, 21) is disposed, and a top dielectric layer covering the circuit;
cutting (100, 101) said unit along parallel cutting planes that are disposed inside respective facing faces (F1, F3) of said unit so as to cause two new faces (Fa, Fb) to appear, respective sets of ends of ground conductors and of a signal conductor then appear thereon, each set being associated with a respective coplanar line;
metal plating said two new faces (Fa, Fb); and
etching the metal-plated new faces so as to form a link coplanar line connecting the ends of ground conductors and of a signal conductor of an input coplanar line of a first elementary structure to respective ends of ground conductors and of a signal conductor of an output coplanar line of a second elementary structure.

10. A method according to claim 9, **characterized in that** it further includes the following steps:
re-molding the etched unit so as to cover the link coplanar line with a dielectric casing;
machining the re-molded etched unit through at least one of its faces at points facing the edges of a ground element so as to form access perforations between each ground element and the outside; and
shielding the unit by metal plating the entire unit, said shielding being in electrical connection with the ground elements via said metal-plated access perforations.

11. A method according to claim 10, **characterized in that** it further includes a step in which at least one face of said metal-plated unit is etched so as to form low-frequency link wires.

12. A method according to claim 11, **characterized by** the following iterative steps: re-molding said etched metal-plated unit, laser machining, metal plating and then etching so as to form multi-layer low-frequency wires.
